# EUROPEAN PATENT SPECIFICATION

(11) **EP 0 298 116 B1**
(45) Date of publication and mention of the grant of the patent: **27.08.1997**
(21) Application number: 88901669.7
(22) Date of filing: 12.01.1988
(51) Int. Cl.: G03F 9/00, G03C 5/00

(54) **LIGHT FILTERS FOR MICROELECTRONICS**
LICHTFILTER FÜR DIE MIKROELEKTRONIK
FILTRES DE LUMIERE UTILISES EN MICROELECTRONIQUE

(30) Priority: 12.01.1987 US 2107
(43) Date of publication of application: 11.01.1989
(73) Proprietor: Brewer Science, Inc., Rolla Missouri 65401 (US)
(72) Inventor: BREWER, Terry, L., Rolla, MO 65401 (US); HAWLEY, Dan, W., St. James, MO 65559 (US); LAMB, James, E., Rolla, MO 65401 (US); LATHAM, William, J., Rolla, MO 65401 (US); STICHNOTE, Lynn, K., Cuba, MO 65453 (US)
(74) Representative: Ruffles, Graham Keith
(86) International application number: US8800042
(87) International publication number: WO8805180

(56) References cited:
- EP-A- 0 134 697
- EP-A- 0 240 378
- GB-A- 2 081 462
- JP-A-58 040 507
- JP-A-58 100 108
- JP-A-60 237 403
- JP-A-61 077 804
- JP-A-61 099 102
- JP-A-62 150 202
- US-A- 4 315 978
- US-A- 4 345 011
- US-A- 4 355 087
- US-A- 4 388 387

## Description

### Technical Field

In recent years many electronic devices have been developed which emit or in someway modulate light, or which sense or emit light of particular spectra. In the microelectronics industry in particular, videocameras, flat panel displays and other devices require the ability to sense or emit colored light. This is typically accomplished by incorporating filters into the device, either directly as a monolithically integrated structure or by "hybrid" technology. Applicants' invention relates to electronic devices incorporating color filters, to methods of producing filters and to the novel filters produced.

### Background Art

A conventional device having filters is disclosed in. U.S. Patent 4,355,087. A typical technique for producing conventional filters is described in U.S. Patent 4,315,978. These filters require a multi-step process using protective layers between the elements of the filter. As a result, the different color elements of the filter are on separate levels. The use of color filters in videocameras and similar devices is described in "Heat-and-Integrated Color Filters," N. Kioke et al., and "Color Filters and processing Alternatives For One-Chip Cameras," K. Parulski, IEEE Transactions on Electron Devices, vol. Ed-32, no. 8, August 1985, the disclosures of which are incorporated by reference herein.

GB-A-2081462 discloses a method for manufacturing colour filters by incorporating the dye and hardener into a solution of a polymer, such as polyamide dissolved in formic acid. The problem is that polymers useful in this method only exhibit poor dye retention, so that protective layers must be used to prevent dye leakage.

JP-A-61077804 discloses a microphotolithographic process for the preparation of filters. A first layer containing a dye and a polyimide precursor is coated onto a substrate and baked to cure the layer and then a second layer of photoresist is coated onto this layer, exposed and developed by wet etching. The problem with wet etching is that it necessarily involves a solution to etch away layers of gel which, with the extremely small size of the elements to be formed can lead either to partial etching of elements or incomplete etching of unwanted areas of dye.

### Disclosure of the Invention

The process of the present invention is as defined in Claims 1 to 7. In addition, the invention also provides filters in accordance with Claims 8 and 9.

In accordance with the present invention, there has been developed a process of producing color filters which places all of the filter elements on the same level. No protective or planarizing layers are required. Applicants' process uses a polymer and dye combination having a dye which is at least partially soluble in the polymer. The polymer and dye solution is applied as a thin film which has excellent film integrity. The film is continuous and uniform and has excellent mechanical, chemical and electronic properties compatable with the requirements of electronic devices. For example, applicants' polymer and dye may be consistently applied at thicknesses as low as about 0.1 micron and up to 25 microns or more. The polymer and dye nave high color resolution in the specific wave length range chosen. The colors can be red, green, blue or other conventional colors such as yellow, cyan, magenta. The filters formed by applicants' material may be applied in arrays, for example in stripe or checkerboard arrays to form color pixels, for videocameras and video displays and the like. In addition, the applicants' material may be used to form single color filters, for example, for photographic purposes. The filters formed may be for any particular light spectra, both in visible and invisible wave lengths, such as infra red and ultra violet wave lengths.

Applicants' invention preferably uses a polymer precursor, such as a polyamic acid, or other polymers, such as PMMA, and soluble dyes which form a uniform coating with extremely good insulating properties, good adhesion properties, wet and dry development characteristics with a conventional photoresist system and a very high light transmission in the desired wavelengths, for example to create the colors red, blue and green, and very high rejection of light at wavelengths not desired. Applicants' coating material has a film thickness compatible with electronic and electrical devices and has a very high resolution of features compatible with such electrical and electronic devices. Elements as small as eight microns or less can be patterned. The light absorbing film demonstrates extremely good thermal, chemical, and aging stability and may remain an integral part of an electrical or electronic device. For example, applicants' filters will remain stable and provide consistent color transmission, in a videocamera for example, over a lifetime of service. The excellent chemical resistance is especially useful in hostile or corrosive environments, including low pressure and low gravity, as encountered in space exploration.

Applicants' material provides excellent adhesion to conventional substrates including glass, silicon, silicon dioxide, aluminum, silicon nitride and polymers, for example polyimides and photoresist. Applicants' material can be cured by conventional means, such as baking at elevated temperatures, or with. the appropriate polymers can be cured by radiation, such as microwave, UV, or IR or can be chemically cured. Applicants' material is compatable with conventional resist systems, substrates and adhesion promoters. The cured system has excellent optical clarity. The resin and dye system is highly compatable and the cured material has a very low (or very slow) solubility. No intermediate or protective layers are required when placing plural filters in a filter array. The colors of adjacent filter elements may be overlapped for greater contrast, if desired. Color control and reproducibility is excellent. The dye is incorporated into the vehicle prior to application of the vehicle to the substrate so that no inconsistent color absorption is encountered. The electrical properties of applicants' material are also superior; the material has very high resistivity and high dielectric strength.

### Brief Description of the Drawings

Figure 1 is a schematic view of a monolithically integrated color filter and sensor for a videocamera and the like using applicants' process and material;
Figure 2 is a schematic view of a hybrid color filter and sensor for a videocamera and the like using applicants' process and material;
Figure 3 is a schematic view of a videocamera and monitor incorporating a color filter and sensor, as shown in Figures 1 and 2;
Figure 4 is a flow diagram for a conventional process of producing color filters;
Figure 5 is a flow diagram for applicants' process of producing color filters;
Figure 6 is a schematic view of a liquid crystal flat panel display using applicants' monolithically integrated filter;
Figure 7 is an alternative flat panel display using a hybrid filter construction, and
Figure 8 is a further alternative flat panel display.

### Best Mode for Carrying Out the Invention

Applicants' coating material has a very broad application. For example, it may be used to replace state of the art "hybrid" filters and monolithically integrated filters. It may be used to make "hybrid" filters and it may be used to integrate filters directly into electronic devices. For example, applicants' filters may be used to make color videocameras and flat panel displays for television and the like, and photographic filters of very high resolution and color transmission.

Applicants' material includes a polymer or a polymer precursor and soluble dyes that are effective to form a uniform, thin, tightly bonded continuous film with good insulating properties, good adhesion properties and dry etch development properties with photoresist systems. Applicants' filters have high color resolution in the desired wavelength range or ranges, for example, the primary colors red, green and blue. Other colors may be used if desired. The film thickness is compatible with electrical and electronic devices and the coating has high resolution required by electrical and electronic devices, such as microelectronic devices. The light transmitting film also demonstrates good thermal, chemical and aging stability necessary to remain an integral part of an electrical system.

The coating material is a solution containing a vehicle, such as a polyimide or polyimide precursor and a solvent soluble dye or dyes. The material has very high resistivity and very high dielectric strength and does non interfer with performance of electrical or electronic devices on which it is coated. The material has no large particles, since it is a solution, and coatings are very uniform. Applicants' material adheres very well to silicon, silicon oxide, aluminum and other conventional substrates.

Applicants' product may be used and applied in a conventional manner. The material may be spun or sprayed on any conventional microelectronic substrate. For example, spinning at 5000 rpm will typically give a film which is 1.5 microns thick. The material may be baked to remove solvent and to crosslink the polymer precursor. The resist is baked, exposed and developed as is conventional in the art. Applicants' coating layer may develop out where the photoresist is removed and so may be patterned at the same time as the photoresist. A layer of aluminum or other suitable etch mask may be deposited on top of the coating layer and patterned prior to etching. The substrate is then placed in a chamber for a reactive ion or plasma etching and the coating layer is etched out in areas not covered by the etch mask. After patterning the light absorbing layer may be baked at a higher temperature to harden the polymer.

The coating and patterning steps may be repeated to place multiple color elements on the same substrate. For example, the process may be performed to place a first set of spaced elements or pixels of a given color (red) on the substrate, repeated to place a second set of a different color (blue) on the substrate and repeated again to place a third set of another color (green) on the substrate. This process is shown schematically in Figure 5. The number and proportions of the colors in the array may be varied, as desired. It is conventional to use twice the number of green pixels as red and blue for some applications, such as video.

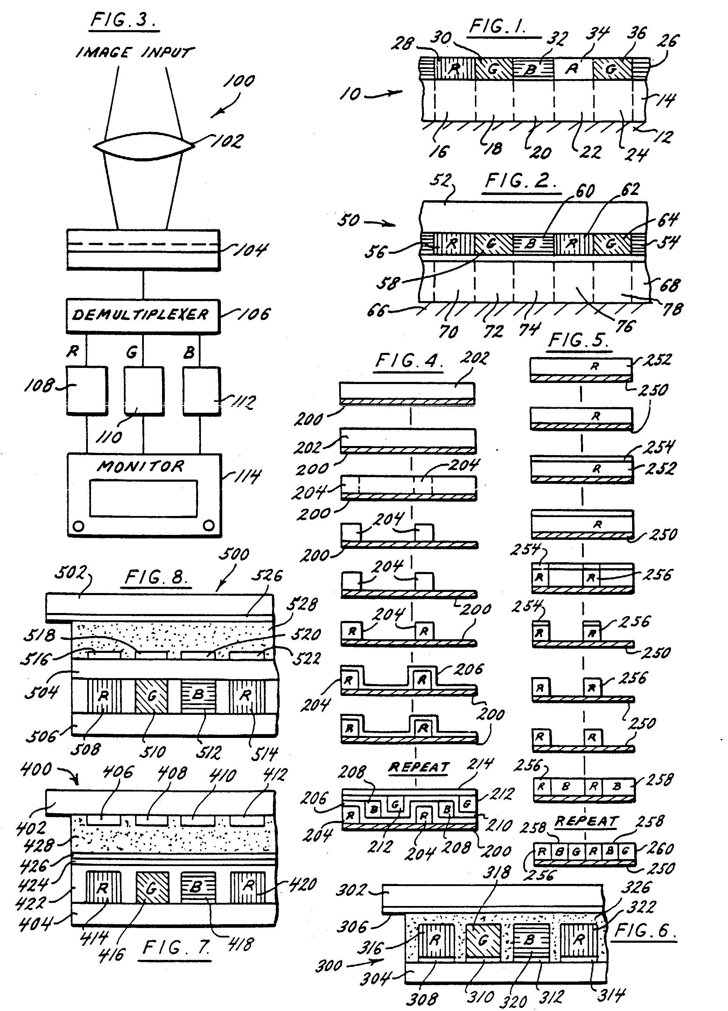

As shown in Figure 1, a monolithically integrated filter 10 may be prepared on a microelectronic substrate 12, as shown. The substrate 12 may have an electrode layer 14 thereon which may be made up of individually addressable electrodes 16, 18, 20, 22 and 24, as is known in the art. A filter layer 26 is deposited and patterned directly on the electrodes in a planar layer, as described herein. The filter layer may have individual color elements, for example red, green and blue, 28, 30, 32, 34 and 36, as shown, on the electrodes.

As shown in Figure 2, a "hybrid" filter 50 is prepared using a glass substrate 52. Glass substrate 52 may have a planar array 54 of filters, for example red, green and blue, made up of individual color elements 56, 58, 60, 62 and 64, as shown. The filter elements are deposited and patterned on the glass substrate 52 as described herein. The glass substrate 52 having filter array 54 thereon is then placed on a microelectronic substrate 66 having an electrode layer 68 thereon, as shown. The electrode layer may have individually addressable electrodes 70, 72, 74, 76 and 78. The glass substrate 52 may be placed on microelectronic substrate 66 so that individual filter elements 56, 58, 60, 62 and 64 are in register with electrodes 70, 72, 74, 76 and 78, as is known in the art.

Applicants' filters, such as filter 10 or filter 50, may be incorporated into a videocamera 100, as shown in Figure 3. 'The videocamera 100 may have a conventional lens 102 and a filter 104, which may be a filter such as either filter 10 or filter 50 previously described. The output from filter 104 is fed through a multiplexer 106 and then through gamma correction 108, 110 and 112. The output signal may then be fed to a monitor 114. It will be appreciated that the signal may also be recorded on conventional tape or other medium, e.g., in digitized form.

In the conventional gelatin process, as shown in Figure 4, a substrate 200 is coated with a gelatin resist 202. The substrate 200 and resist 202 coated thereon are prebaked to set the gelatin resist 202. The resist 202 is exposed to the influence of light and a pattern, to pattern the gelatin resist layer 202. The gelatin layer 202 is then developed to form gelatin structures 204 on the substrate 200. The gelatin structures 204 are then baked a second time and subjected to a dye solution, for example red, which impregnates the gelatin structures 204. The dyed gelatin structures 204 are then coated with a protective layer 206 and the protective layer 206 is then cured to render it insoluble. The process is then repeated, for example a second and then a third time, to prepare a final filter on substrate 200 having red dyed gelatin structures 204 covered by a protective layer 206, blue dyed gelatin structures 208 on protective layer 206 covered by a subsequent protective layer 210 and green dyed gelatin structures 212 on protective layer 210. The green structures 212 are coated with an overall protective layer 214, which protects and planarizes the entire structure.

In contrast, as shown in Figure 5, applicants prepare a monolithic filter on a substrate 250 by coating a vehicle 252 such as a polyamic acid (polyimide precursor) on substrate 250. The vehicle 252 contains the soluble filter dye as described herein. The substrate 250 and vehicle 252 are then prebaked to insolublize the resin 252 and a photoresist 254 is then coated over the resin 252 and given a second prebaking. The photoresist 254 is then exposed to pattern the photoresist 254 and resin layer 252 underneath and developed to form the structure 256, for example red color elements, on the substrate 250. The photoresist 254 is then removed to expose color elements 256 on substrate 250 and the color filter elements 256 are then baked to further insolublize the filter elements 256. The process may then be repeated, for example a second and then a third time, to form an array on substrate 250 having separate color elements, for example red 256, blue 258 and green 260, as shown. As can be seen in Figure 5 the array of filter elements is a substantially planar array and does not require any separating or covering protective layers. The array thus can provide maximal optical characteristics. That is, the scattering or bending of light through the filter is at a minimum due to the filter's planar construction.

Depending upon the method and the application, the light absorbing layer may be a few microns to a few tenths of microns in thickness. Spinning typically yields films from one micron to ten microns in thickness. Conventional spraying produces films which may be as thick as twenty-five microns. Applicants' product is unique in that very small geometries can be patterned in it. Dry etch processing in accordance with the invention can resolve lines smaller than one micron.

Applicants' coating becomes substantially insoluble in conventional solvents, once the film has been baked. Consequently, plural application of color elements does not require the use of intermediate protective or planarizing layers between applications of each color of filter elements in an array. Moreover, the dyes are incorporated in the coatings prior to the application of the coating to the substrate. The application of the coating with the dye incorporated eliminates the steps of dyeing the elements after the coatings have been applied. Unlike gelatin color filters, dyes are contained in the applicants' filter when it is deposited. This permits far better control over the spectral characteristics of the filters. In the process of dyeing gelatin, many variables limit reproducibility. These include dye concentration, pH, and temperature of the dye bath, as well as the length of time the gelatin is immersed in the bath. Also, the nature and thickness of gelatin are important variables. Gelatin (fish glue) is a poorly characterized material, the physical and chemical properties of which may vary widely.

The resistivicy of the coatings is typically 3 x 10¹⁵ ohm-cm or more and the dielectric strengtn typically exceeds 7 x 10⁵ volts per centimeters. These are outstanding electrical characteristics for an organic film and far better than conventional material.

The vehicle for applicants' filter layer may typically include a polyimide precursor which reacts in use to form a polyimide resin. The precursor typically includes a polyamic acid for example prepared by reacting oxydianiline (ODA) with pyromellitic dianhydride (PMDA) or prepared by reacting ODA with PMDA and benzophenone tetracarboxylic dianhydride (BTDA). Other equivalent polyamic acids and polyimide precursors may be used. The reactants for the polyimide precursors are typically included in approximately stoichiometric amounts. Some formulations may include at least some water soluble polymers and other additives, such as silanes, plasticizers, antioxidants, cross-linking agents and other conventional additives. Other polymers may also be used, including PMMA, 4-aminophenyl sulfone (4-APS), 3-aminophenyl sulfone (3-APS), bis (aminophenoxyphenyl sulfone) (BAPS), vinyl pyridine polymers, malic anhydride polymers and mixtures and copolymers thereof. The dyes may be chosen from soluble organic dyes which are effective to absorb the particular color desired. The primary colors red, blue and green are preferred for some applications. Other dye combinations, such as yellow, cyan and magenta may also be used.

Exemplary dyes are as follows, it being understood that the dyes may be combined to form colors other than the red, blue, green primary colors which are given for purposes of illustration and that other suitable dyes and dye combinations may also be used:

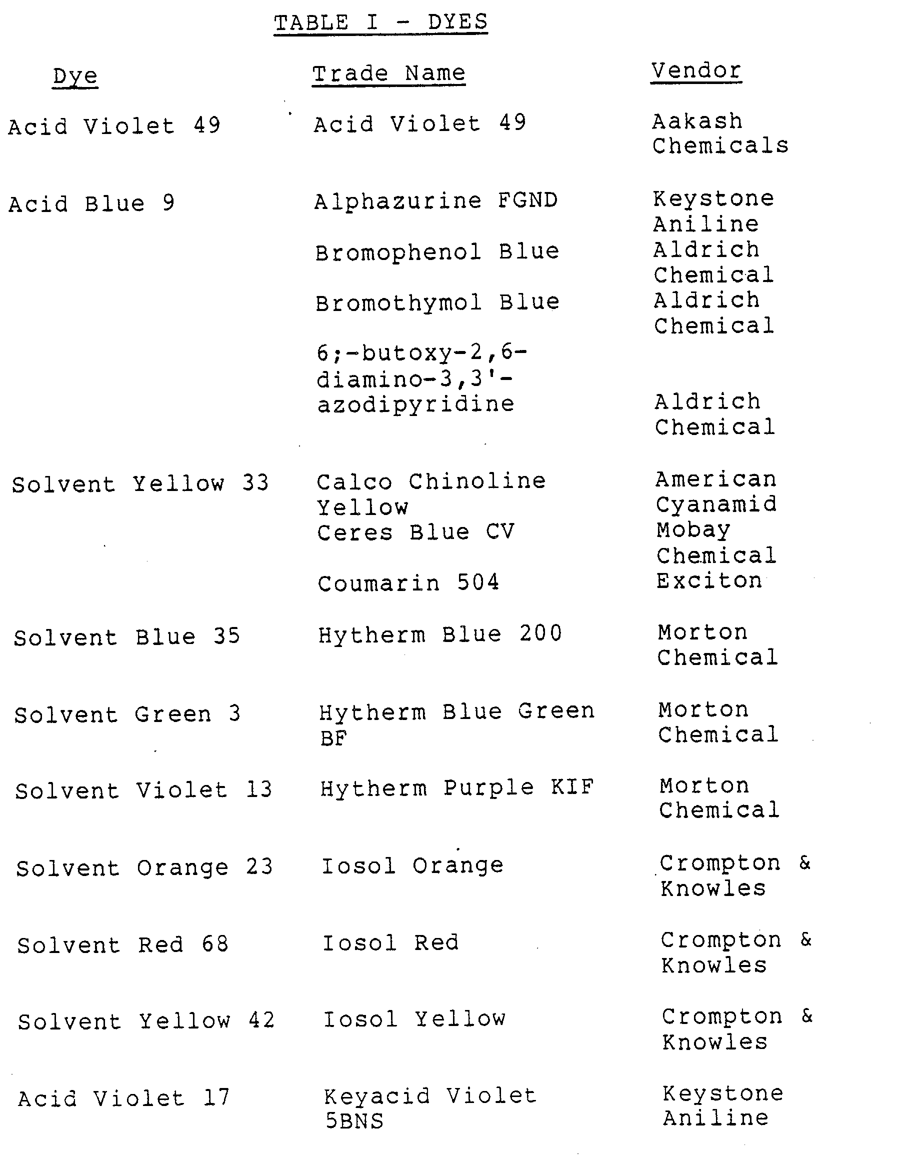

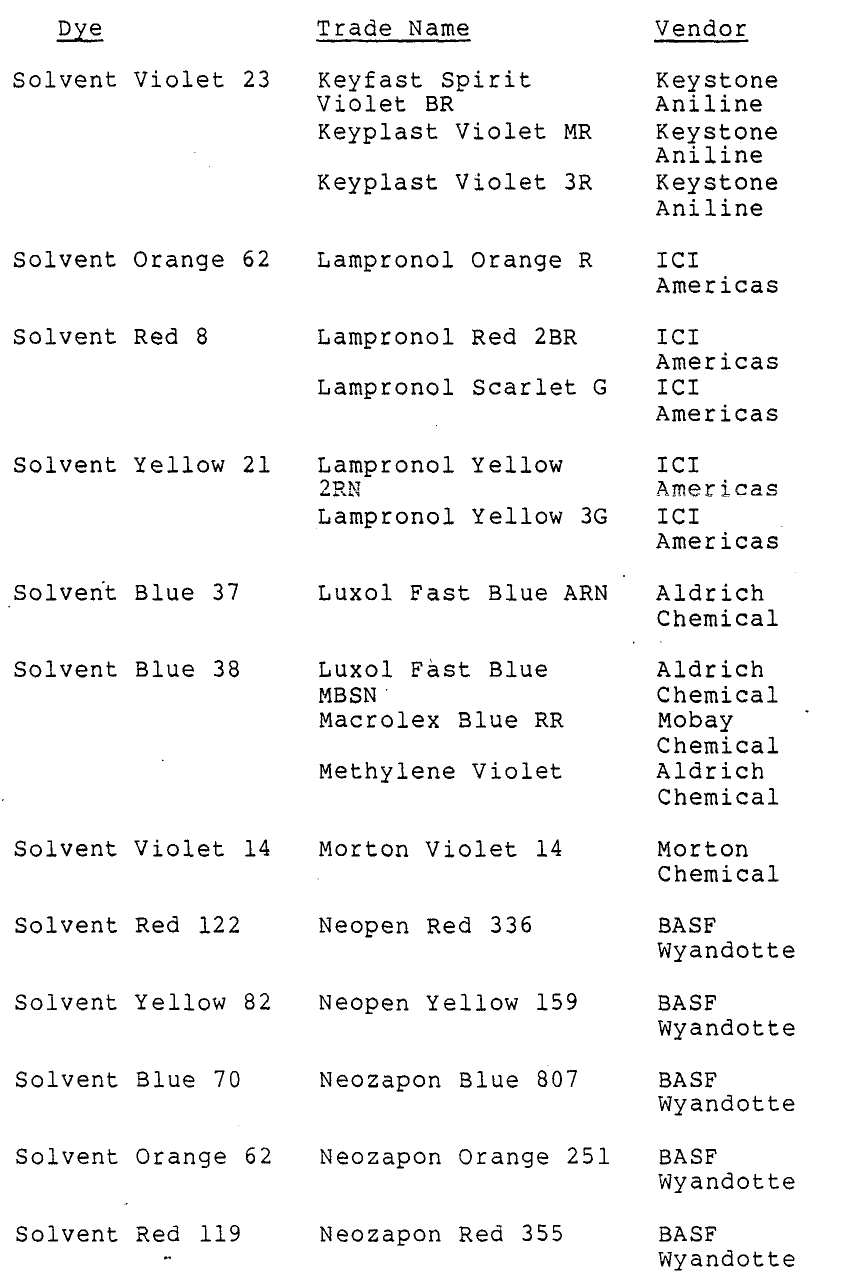

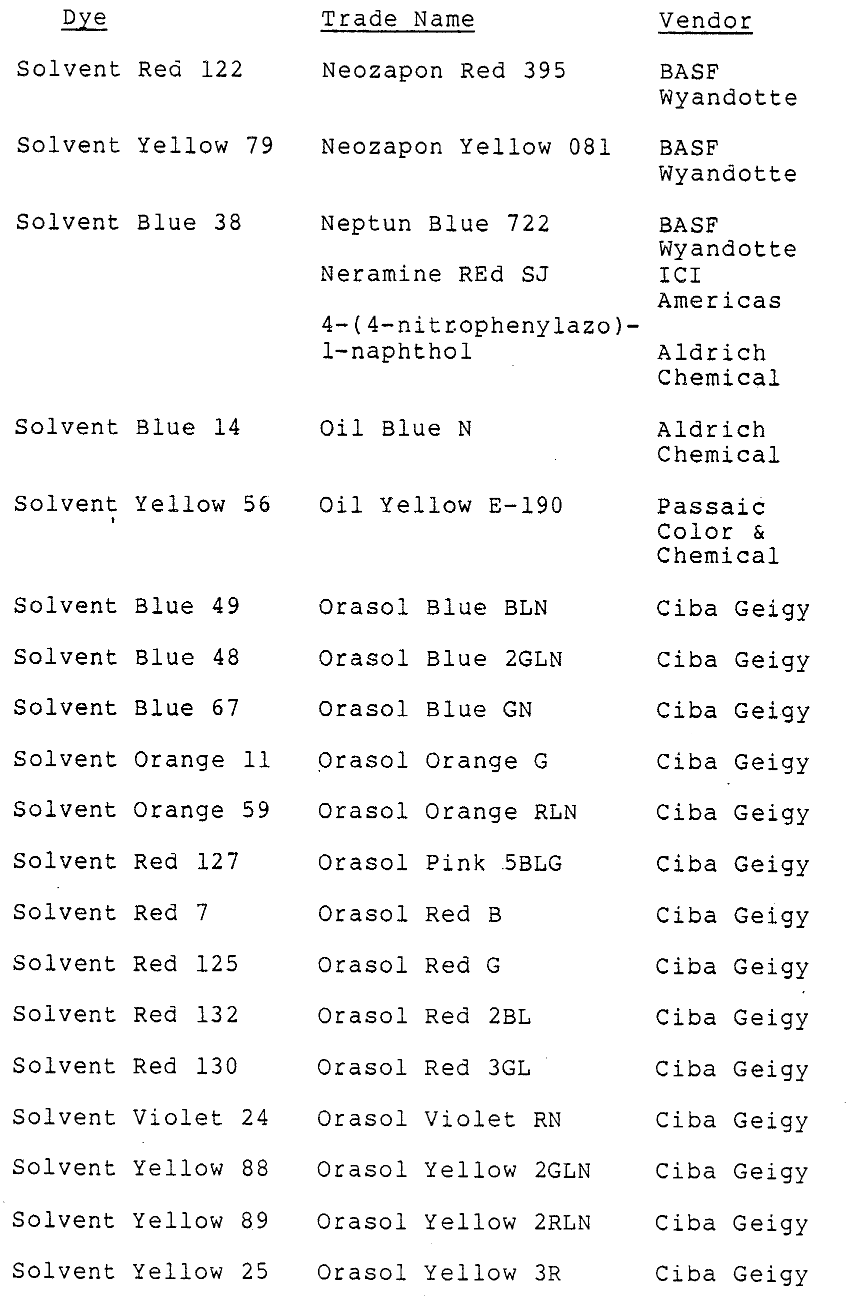

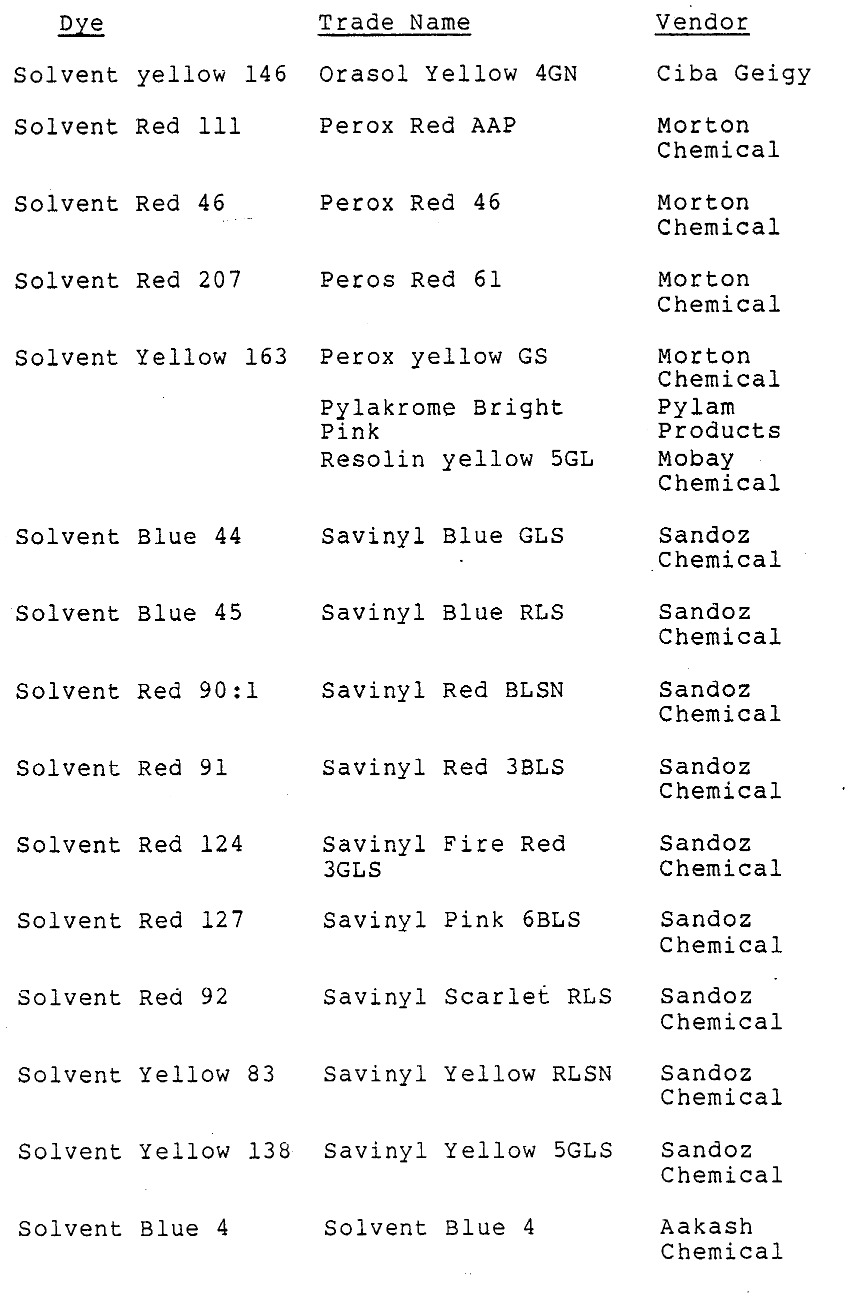

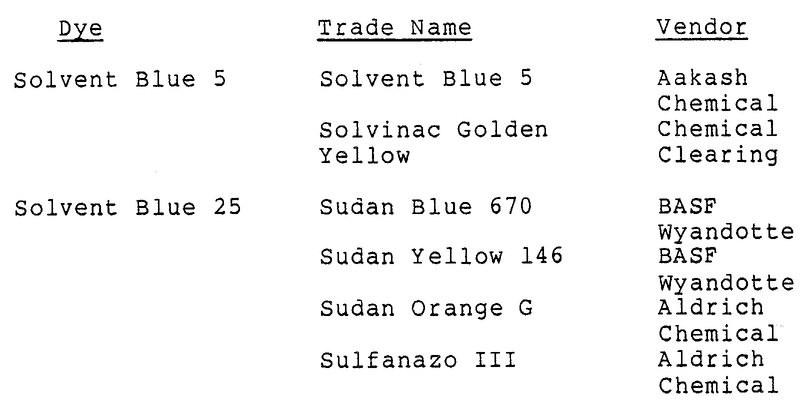

### Red Coatings

Red coatings may be prepared by dissolving a resin vehicle in a solvent, as described herein, with one or more of the following yellow dyes in combination with one or more of the following red dves.

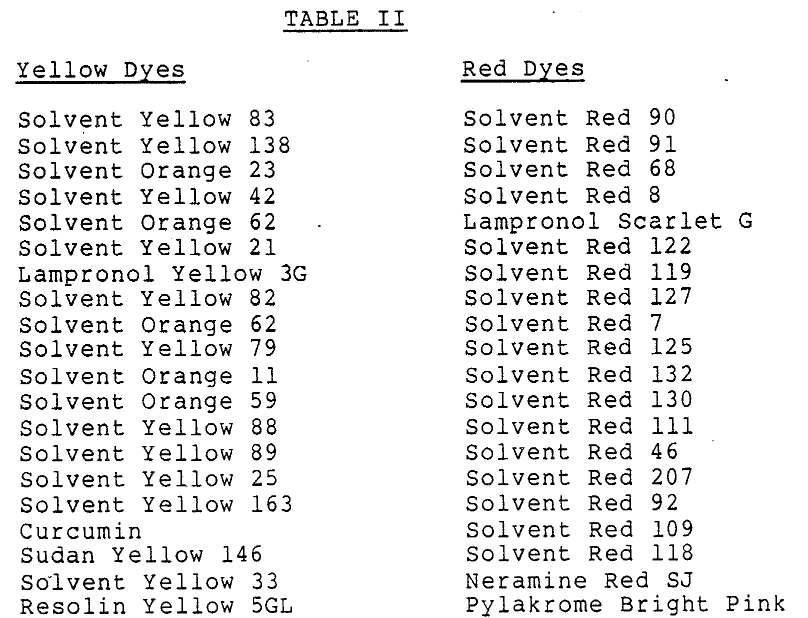

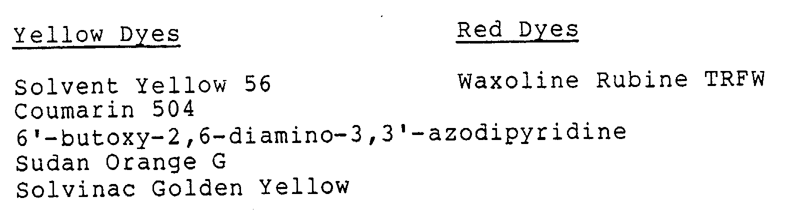

### Green Coatings

Green coatings may be prepared by dissolving a resin vehicle in a solvent, as described herein, with one or more of the following yellow dyes in combination with one or more of the following blue dyes:

**TABLE III**

| Yellow Dyes | Blue Dyes |
|---|---|
| Solvent Yellow 83 | Solvent Green 3 |
| Solvent Yellow 138 | Solvent Blue 38 |
| Solvent Yellow 42 | Solvent Blue 70 |
| Solvent Yellow 21 | Solvent Blue 38 |
| Lampronol Yellow 3G | Solvent Blue 48 |
| Solvent Yellow 82 | Solvent Blue 67 |
| Solvent Yellow 79 | Solvent Blue 44 |
| Solvent Yellow 88 | Solvent Blue 25 |
| Solvent Yellow 89 | |
| Solvent Yellow 25 | |
| Solvent Yellow 146 | |
| Solvent Yellow 163 | |
| Solvent Yellow 21 | |

### Blue Coatings

Blue coatings may be prepared by dissolving a resin vehicle in a solvent, as described herein, with one or more of the following blue dyes:

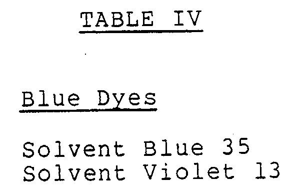

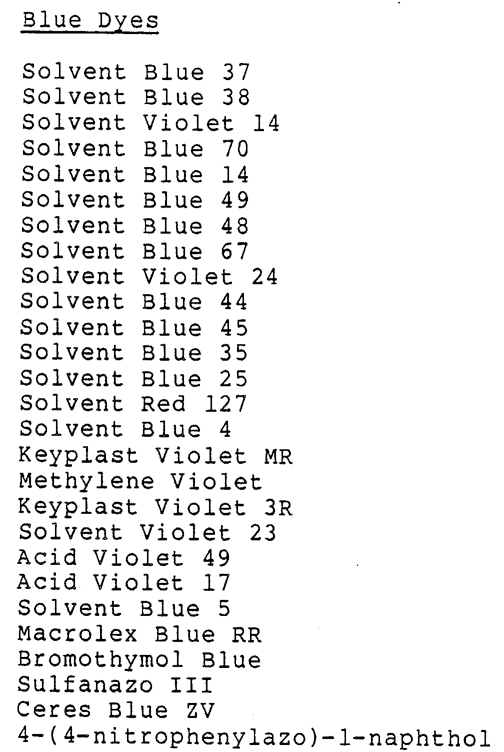

The dyes and vehicle or vehicle precursor are included with a solvent system so that the entire system is cosoluble. A typical solvent would include cyclohexanone, NMP (N-methyl pyrrolidone), cellosolves, ethers, chlorobenzene, glycols, ketones, water and similar solvents which are effective to cosolubilize the resin and dye.

## Claims

1. A microphotolithographic process for the preparation of microelectronic filters (10) for video cameras and the like, comprising providing a liquid layer (252) of a vehicle and a dye on a substrate (250), the vehicle being a solution of a polymer precursor in a solvent therefor, the dye also being dissolved in the solvent, baking the layer (252) and subsequently coating the baked layer (252) with a second layer (254) of a photoresist, exposing and developing the layers (252, 254) to remove unwanted areas of the dye-containing layer, and optionally repeating the process with the same or a different dye(s), characterised in that the removal of unwanted areas the dye-containing layer is by dry-etching.

2. A process according to claim 1, wherein the two layers (252, 254) are developed in one step.

3. A process according to claim 1 or 2, wherein the polymer precursor is a polyimide precursor.

4. A process according to any preceding claim, wherein the vehicle is selected from readily soluble polyamic acid precursors of polyimide resins, polymers and copolymers of polyimide resins, and combinations thereof with water soluble resins.

5. A process according to any preceding claim, wherein the vehicle is selected from polyamic acid precursors of polyimide resins.

6. A process according to any preceding claim, wherein the vehicle is selected from oxydianiline and pyromellitic dianhydride or oxydianiline, pyromellitic dianhydride and benzophenone tetracarboxylic dianhydride, the vehicle components being present in approximate stoichiometric amounts.

7. A process according to any preceding claim, wherein the vehicle includes polymethyl methacrylate, 4-aminophenylsulphone, 3-aminophenylsulphone, or bis(aminophenoxyphenyl)sulphone.

8. A microelectronic filter (10) as defined in claim 1, comprising arrays of coloured elements (256, 258, 260) in a substantially planar monolithic structure on a substrate (250) therefor, the elements (256, 258, 260) consisting essentially of a cross-linked polymer and one or more suitable dyes, optionally together with antioxidants, cross-linking agents, plasticisers and/or additives.

9. A filter according to Claim 8, wherein said cross-linked polymer is a polyimide.

## Patentansprüche

1. Mikrolithographisches Verfahren zur Herstellung mikroelektronischer Filter (10) für Videokameras und dergleichen, mit den Schritten: Bereitstellen einer Flüssigkeitsschicht (252) aus einem Bindemittel und einem Farbstoff auf einem Substrat (250), wobei das Bindemittel eine Lösung aus einem Polymervorläufer in einem dafür geeigneten Lösungsmittel ist und der Farbstoff gleichfalls in dem Lösungsmittel gelöst ist, Härten der Schicht (252) und anschließend Überziehen der gehärteten Schicht (252) mit einer zweiten Schicht (254) aus einem Photoresist, Belichten und Entwickeln der Schichten (252, 254), um unerwünschte Bereiche der farbstoffhaltigen Schicht zu entfernen, und wahlweise Wiederholung des Prozesses mit einem oder mehreren gleichen oder anderen Farbstoffen, dadurch gekennzeichnet, daß das Entfernen unerwünschter Bereiche der farbstoffhaltigen Schicht durch Trockenätzen erfolgt.

2. Verfahren nach Anspruch 1, wobei die beiden Schichten (252, 254) in einem Schritt entwickelt werden.

3. Verfahren nach Anspruch 1 oder 2, wobei der Polymervorläufer ein Polyimidvorläufer ist.

4. Verfahren nach einem der vorstehenden Ansprüche, wobei das Bindemittel unter leichtlöslichen Polyamidsäurevorläufern von Polyimidharzen, Polymeren und Copolymeren von Polyimidharzen und deren Kombinationen mit wasserlöslichen Harzen ausgewählt wird.

5. Verfahren nach einem der vorstehenden Ansprüche, wobei das Bindemittel unter Polyamidsäurevorläufern von Polyimidharzen ausgewählt wird.

6. Verfahren nach einem der vorstehenden Ansprüche, wobei das Bindemittel unter Oxydianilin und Pyromellitsäuredianhydrid oder Oxydianilin, Pyromellitsäuredianhydrid und Benzophenontetracarbonsäuredianhydrid ausgewählt wird, wobei die Bindemittelkomponenten in ungefähr stöchiometrischen Mengen vorhanden sind.

7. Verfahren nach einem der vorstehenden Ansprüche, wobei das Bindemittel Polymethylmethacrylat, 4-Aminophenylsulfon, 3-Aminophenylsulfon oder Bis(aminophenoxyphenyl)sulfon aufweist.

8. Mikroelektronisches Filter (10) gemäß der Definition in Anspruch 1, mit Matrixanordnungen farbiger Elemente (256, 258, 260) in einer im wesentlichen planaren monolithischen Struktur auf einem dafür geeigneten Substrat (250), wobei die Elemente (256, 258, 260) im wesentlichen aus einem vernetzten Polymer und einem oder mehreren geeigneten Farbstoffen bestehen, wahlweise zusammen mit Antioxidationsmitteln, Vernetzungsmittel, Weichmachern und/oder Zusätzen.

9. Filter nach Anspruch 8, wobei das vernetzte Polymer ein Polyimid ist.

## Revendications

1. Procédé de microphotolithographie pour la préparation de filtres microélectroniques (10) pour caméras vidéo et similaires, consistant à fournir une couche liquide (252) d'un véhicule et d'un colorant sur un substrat (250), le véhicule étant une solution d'un précurseur de polymère dans un solvant pour celui-ci, le colorant étant aussi dissous dans le solvant, à faire cuire la couche (252) puis à revêtir la couche (252) cuite avec une seconde couche (254) d'une photoréserve, à exposer et développer les couches (252, 254) pour éliminer les zones non voulues de la couche contenant un colorant, et à répéter éventuellement le traitement avec le(s) même(s) colorant(s) ou un (des) colorant(s) différent(s), caractérisé en ce que l'élimination des zones non voulues de la couche contenant un colorant est effectuée par gravure par voie sèche.

2. Procédé selon la revendication 1, dans lequel les deux couches (252, 254) sont développées en une étape.

3. Procédé selon la revendication 1 ou 2, dans lequel le précurseur de polymère est un précurseur de polyimide.

4. Procédé selon l'une quelconque des revendications précédentes, dans lequel le véhicule est choisi parmi les précurseurs acides polyamiques, aisément solubles, de résines polyimides, les polymères et copolymères de résines polyimides, et les combinaisons de ceux-ci avec des résines hydrosolubles.

5. Procédé selon l'une quelconque des revendications précédentes, dans lequel le véhicule est choisi parmi les précurseurs acides polyamiques de résines polyimides.

6. Procédé selon l'une quelconque des revendications précédentes, dans lequel le véhicule est choisi parmi l'oxydianiline et le dianhydride pyromellitique, ou l'oxydianiline, le dianhydride pyromellitique et le dianhydride benzophénone tétracarboxylique, les constituants du véhicule étant présents en des quantités stoechiométriques approximatives.

7. Procédé selon l'une quelconque des revendications précédentes, dans lequel le véhicule inclut un méthacrylate de polyméthyle, la 4-aminophénylsulfone, la 3-aminophénylsulfone ou la bis(aminophénoxyphényl)sulfone.

8. Filtre microélectronique (10) tel que défini dans la revendication 1, comprenant des rangées d'éléments colorés (256, 258, 260) en une structure monolithique substantiellement plane sur un substrat (250) pour ceux-ci, les éléments (256, 258, 260) étant essentiellement constitués par un polymère réticulé et un ou plusieurs colorants appropriés, éventuellement avec des antioxydants, des agents de réticulation, des plastifiants et/ou des additifs.

9. Filtre selon la revendication 8, dans lequel ledit polymère réticulé est un polyimide.
